# EUROPEAN PATENT APPLICATION

(11) **EP 1 465 264 A1**
(43) Date of publication of application: **06.10.2004**
(21) Application number: 03354030.3
(22) Date of filing: 04.04.2003
(51) Int. Cl.: H01L 39/24, C30B 29/22, C30B 33/00

(54) **Manufacture of high critical temperature superconducting part using uniaxial pressure during oxygenation step**

(71) Applicant: CENTRE NATIONAL DE LA RECHERCHE SCIENTIFIQUE (CNRS), 75794 Paris Cedex 16 (FR); The University of Cincinnati, Cincinnati, Ohio 45202 (US)
(72) Inventor: Shi, Donglu, Loveland, Ohio 45140 (US); Tournier, Robert, 38850 Bilieu (FR); Chaud, Xavier, 38600 Fontaine (FR); Isfort, Dirk, 50937 Köln (DE)
(74) Representative: de Beaumont, Michel

(57) **Abstract**

A manufacturing method of a single domain of a rare earth based superconducting oxide having a high critical temperature at a given oxygen rate, to be used as a superconductor having different electromagnetic properties in a privileged plane (ab) and in a privileged direction (c), respectively, comprising the manufacture of a single domain (20) of the rare earth based superconducting oxide at an intermediate oxygen rate lower than the given oxygen rate from grains or precursors of the rare earth based superconducting oxide; and the oxygenation of the single domain to increase the oxygen rate of the rare earth based superconducting oxide from the intermediate oxygen rate up to the given oxygen rate, wherein, during oxygenation, an uniaxial pressure is applied on the single domain along the c-axis.

## Description

The present invention relates to a manufacturing method of a part made of a high critical temperature superconducting material.

More specifically, the present invention relates to a manufacturing method of a rare earth based superconducting oxide single domain part having a high critical temperature, for example a REBCO single domain. It will be understood that REBCO single domain means an imperfect single crystal domain of REBa₂Cu₃Oₓ, where RE stands for Rare Earth and x is characteristic of the oxygen rate. The single crystal is said to be imperfect since it may contain defects such as inclusions of other phases, voids, growth defects, etc. The rare earth can be yttrium (Y). YBa₂Cu₃Oₓ single domain will be called hereafter YBCO single domain.

REBCO single domains usually act like superconductors with high performances in critical current density, especially for high magnetic fields. Therefore, they are used to manufacture current limiters, magnetic bearings, motors or permanent magnets.

The manufacture of a superconducting REBCO single domain usually requires two steps.

The first step consists in manufacturing a REBCO single domain, for example by way of a Top-Seeding-Melt-Texturing method. The single domain obtained is usually an imperfect crystal of a REBa₂Cu₃Oₓ phase, called hereafter RE123 phase, with inclusions of a RE₂BaCuO₅ phase, called hereafter RE211 phase. The crystal structure of RE123 phase is strongly anisotropic. The elementary lattice consists in a stack extending in a preferential direction, called c direction, of perovskite type layers in specific planes, called ab planes.

The second step consists of the oxygenation of the REBCO single domain. Indeed, the oxygen rate x of the REBCO single domain obtained at the first step usually varies from 6.1 to 6.2. However, some properties of a YBCO single domain, including the resistivity in normal state, the critical temperature and the critical current, vary according to the oxygen rate x. For current applications, the oxygen rate to achieve is usually superior to 6.9. An oxygenation step is provided to obtain a material with an oxygen rate which corresponds to properties adapted to the wanted application. The oxygenation can be commonly achieved by annealing the single domain under flowing oxygen.

The oxygenated single domains obtained by common oxygenation methods have usually several drawbacks, especially cracks which spread mainly in ab planes. Cracks can appear, at the first step, during the manufacture of the single domain. However, most cracks seem to appear during the oxygenation step. The process which leads to the occurrence of the cracks during the oxygenation step also leads to the spreading of all the cracks which have already appeared during the manufacture of the single domain. Such cracks spoil the superconductivity properties and the mechanical resistance properties of the single domain.

Consequently, the purpose of this invention is to provide the manufacture of a REBCO superconducting part which prevents the formation of cracks in the ab planes during the oxygenation step.

To attain this purpose, the present invention provides a manufacturing method of a single domain of a rare earth based superconducting oxide having a high critical temperature at a given oxygen rate, to be used as a superconductor having different electromagnetic properties in a privileged plane and in a privileged direction, comprising the steps of manufacturing a single domain of the rare earth based superconducting oxide at an intermediate oxygen rate lower than the given oxygen rate from grains or precursors of the rare earth based superconducting oxide; and oxygenating the single domain to increase the oxygen rate of the rare earth based superconducting oxide from the intermediate oxygen rate up to the given oxygen rate, wherein, during oxygenation, a pressure is applied on the single domain along the c-axis.

According to another embodiment of the invention, the manufacturing step of the rare earth based high critical temperature superconducting oxide at the intermediate oxygen rate includes a step of manufacturing an intermediate part by sintering grains of the rare earth based superconducting oxide or grains of precursors of the rare earth based superconducting oxide.

According to an embodiment of the invention, the manufacturing step of the rare earth based superconducting oxide at the intermediate oxygen rate includes a texturing step of the intermediate part by germination from a seed.

According to an embodiment of the invention, the pressure is applied uniformly on the single domain of the rare earth based superconducting oxide at the intermediate oxygen rate.

According to an embodiment of the invention, the pressure is applied through a pressing machine comprising two flanges taking the single domain of the superconducting oxide at the intermediate oxygen rate in sandwich, and means for drawing closer the two flanges.

According to an embodiment of the invention, the rare earth based superconducting oxide is an oxide of barium, copper and the rare earth.

According to an embodiment of the invention, the rare earth is yttrium.

The foregoing and others purposes, features and advantages of the invention will become apparent from the following detailed description of embodiments, given by way of illustration and not limitation with reference to the accompanying drawings:
figure 1 schematically illustrates a conventional manufacturing method of a YBCO single domain; and
figure 2 schematically shows a sectional view of an embodiment according to the present invention of a device which prevents the formation of ab plane cracks in the YBCO single domain during oxygenation.

The present invention will be described with reference to the manufacture of YBCO single domains.

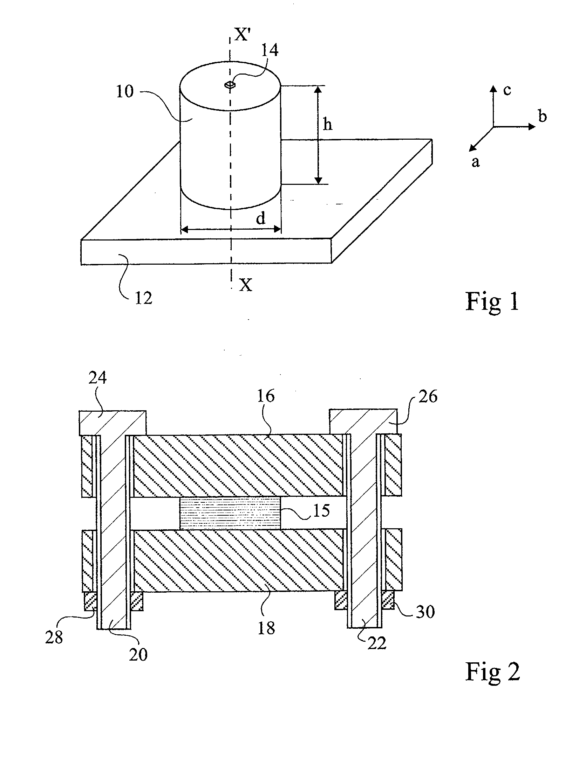

Figure 1 schematically shows a conventional intermediate part used to manufacture a YBCO single domain, for example, by way of a Top-Seeding-Melt-Texturing method. The part includes a cylindrical pellet 10 with height h and diameter d, obtained for example by sintering a powder containing a Y123 phase, a Y211 phase and additives such as platinum oxide or cerium oxide. An example of compound contains 70% per weight of the Y123 phase, 30% per weight of the Y211 phase and 0.15% per weight of platinum oxide in excess. The mixed powder is compacted under a pressure varying for example from 60 MPa to 100 MPa to form the pellet. Sintering is achieved for example by maintaining the part at 980°C for 12 hours.

The pellet 10 is located on a base 12 made of a material which does not disturb the manufacture of the YBCO single domain. The base is, for example, a sintered alumina plate covered by an yttrium oxide layer Y₂O₃, or a Y211 phase layer, or a mixture of the Y123 phase and of a Yb123 phase (a phase of the same composition than the Y123 phase with ytterbium Yb instead of yttrium), etc.

The YBCO single domain is obtained by texturing the sintered pellet 10. Therefore, a single crystal seed 14 of SmBa₂Cu₃Oₓ is located on the face of the pellet 10 opposed to the base 12. The compound SmBa₂Cu₃Oₓ belongs to the same perovskite group as the Y123 phase with a similar crystal structure wherein a samarium atom is substituted for the yttrium atom. The seed can also correspond to a SmBa₂Cu₃Oₓ single domain or MgO crystal. The seed surface in contact with the pellet 10 is orientated in an ab plane to initiate the growth of the YBCO single domain in the same orientation.

The Y123 phase melting point (peritectic point) is about 1015°C. The seed melting point is about 50°C higher than the Y123 phase melting point. The pellet 10 can be heated above the melting point to obtain a complete melting of the Y123 phase grains without damaging the seed 14. The Y211 phase remains solid at such temperatures, whereby the pellet 10 keeps a substantially cylindrical shape. The additives provided in the pellet prevent the Y211 phase from growing excessively in the liquid obtained after the melting of the Y123 phase. After completely melting the Y123 phase, the pellet 10 is cooled to the melting point, and then cooled very slowly, about from 0.1 to 0.5 degree per hour, so that only one Y123 phase grain may grow. A cylindrical YBCO single domain is thus obtained, made of an imperfect Y123 phase single crystal wherein Y211 phase particles are scattered.

According to an alternative, the preshaped pellet is made of a powder containing only the Y123 phase. Indeed, beyond the melting point, the Y123 phase changes into a liquid rich in copper and barium, and into a solid Y211 phase. The only Y211 phase obtained by this way is usually sufficient to maintain the cohesion in the pellet.

According to another alternative, the seed is placed on the pellet during the manufacture of the single domain after overheating the pellet at a temperature at which the seed does not melt and before the slow cooling to grow the single domain. Then, the single domain growth goes on as previously described. An advantage of this alternative is that the overheating temperature is not limited anymore by the melting point of the seed.

According to another alternative, the preshaped pellet does not contain the Y123 phase. The preshaped pellet includes, for example, only the Y211 or the Y₂O₃ phases. The manufacturing method of the YBCO single domain comprises the steps of locating a seed on the pellet, for example made of SmBa₂Cu₃Oₓ, or of NdBa₂Cu₃Oₓ where Nd corresponds to neodymium. The pellet is then heated at high temperature (for example 1050°C) in presence of liquid phase sources, for example solid barium or copper elements located at the preshaped pellet. The high temperature is such that the seed remains solid and the liquid phase sources melt. The obtained liquid phase infiltrates in the pellet by capillarity. A slow cooling is then carried out in presence of the seed so that the liquid phase partially reacts with the pellet in order to form the Y123 phase. The Y123 phase recrystallization in a single domain is driven by the seed as in the first embodiment. The obtained single domain is then a composite material with a Y123 matrix and Y211 inclusions. An advantage of this alternative is that the shape of the pellet remains substantially the same when forming the single domain. Moreover, the distribution of the Y211 phase in the obtained single domain is rather homogeneous. Besides, since the preshaped pellet does not contain the Y123 phase, this phase is not polluted by the manufacturing method of the pellet. The Y211 and Y₂O₃ phases being more stable than the Y123 phase, a rather aggressive manufacturing method can be used for the manufacture of the single domain even if the method could have led to the pollution of the Y123 phase, if present. For example, an extrusion method can be used with a paste comprising the Y211 or the Y₂O₃ phases and a binding material.

The applicant has studied the phenomena underlying the formation of ab plane cracks during oxygenation. Oxygenation is commonly achieved by annealing the YBCO single domain under flowing oxygen with one or several temperature steps.

During oxygenation at temperatures which provide the optimum oxygen rate in the material for maximum current densities, i.e. between 400°C and 500°C at atmospheric pressure, there is a transformation of the single domain from a tetragonal to an orthorhombic phase. The phase transformation is mainly governed by the oxygen diffusion. The applicant has shown that the phase transition creates large volume stress which is responsible for rapid crack propagation in the YBCO crystal. During the tetragonal to orthorhombic transition, both c and a axis of a Y123 crystal unit cell decrease, and accordingly the b axis increases. As a result of the variations along these axes, there is a volume change in the unit cell, which leads to large volume stress. Such a high volume stress can deform the bulk single domain during the oxygenation. For a c-axis oriented single domain YBCO, the volume stress tends to shorten the crystal along the c-axis. However, the structurally isotropic Y211 inclusions prevent the compressive deformation in some local areas especially near the Y211 inclusions, therefore diverting the compressive stress to tensile stress. As the tensile stress reaches a critical value, the cracks start a propagation inwardly in the crystal. The tetragonal to orthorhombic transition phase boundary provides a driving force for the propagation of the cracks and is controlled by the oxygen diffusion. The applicant has also identified a second mechanism for crack occurrence and propagation. The oxygen diffusion coefficient in the ab planes is about from 10⁴ to 10⁶ times larger than in c direction. Accordingly, oxygen diffusion below 900°C can be considered as taking place entirely in the ab planes. Because of the slow oxygen diffusion, steep oxygen gradients build up parallel to the ab planes during oxygen annealing. The c-axis length of the unit cell shrinks when the oxygen rate of the material increases. The surface layers which are more oxygenated shrink in the c direction and are put in tension by the bulk of the material which is not yet oxygenated. The orientation of resulting tensile stresses is in c direction. Therefore these stresses tend to open cracks in the ab planes as well. The oxygen diffusion in the material is faster along the cracks, so that the mechanism described above reproduces itself at the crack tip and provides also a driving force for the crack propagation.

The present invention consists, during the oxygenation step, in applying a pressure along the c-axis to the YBCO single domain. From multiple experiments, the inventors have shown that the application of a uni-axial c-axis pressure to the single domain effectively suppresses the formation of the ab plane cracks on the external surfaces of the YBCO single domain and inside the YBCO single domain. The application of a uni-axial c-axis pressure compensates the local tensile stress from the Y211 inclusions and the oxygen gradients responsible for ab plane cracks. Since local tensile stress is required for a crack to be initiated, the c-axis pressure can provide an effective counter pressure that compensates this local tensile stress. In this way, the crack formation is suppressed.

Figure 2 shows schematically a sectional view of a device according to the present invention which provides the application of a pressure on a YBCO single domain 15. The YBCO single domain 15 is located between two flanges 16, 18 of stainless steel. Several screws 20, 22 (two screws being represented on figure 2) cross through the two flanges, the heads 24, 26 of the screws abutting against one of the flanges. Bolts 28, 30 are adjusted on the screws 20, 22 so that the flanges 16, 18 are taken in sandwich between the screw heads 24, 26 and the bolts 28, 30. The rotation of the screws 20, 22 and/or the rotation of the bolts 28, 30 leads to the application of a pressure on the single domain 15. To ensure a uniform pressure, the top and bottom surfaces of the YBCO single domain 15 are preliminary polished for making these surfaces parallel to each other. Moreover, the device is provided with a pressure gauge (not shown) in order to ensure that the pressure remains constant or to monitor the pressure change during oxygenation, in order to take into account some relaxation effects of the screws and the flanges. For example, for a cylindrical YBCO single domain of 20 mm in diameter and 15 mm in height, a pressure of about 5 MPa is enough to prevent ab plane cracks from spreading. The oxygen brought during the oxygenation step can reach freely the single domain 10 thanks to the interval left between the flanges 16, 18.

The present invention leads to the manufacture of YBCO single domains with a reduced number of cracks in the ab planes. The electromagnetic properties of the single domains used as superconductors are then improved since the material is more homogeneous. Moreover, easily reproducible critical currents can be achieved since the number of cracks are reduced, which is desirable for the manufacture of single domains at an industrial scale. Moreover, mechanical properties of such single domains are improved with regard to commonly manufactured single domains with identical dimensions. Indeed, stronger single domains can be achieved since the number of cracks is reduced.

The present description was made with the example of YBCO. However, the invention applies to other rare earth oxides such as neodymium (Nd), samarium (Sm), gadolinium (Gd), europium (Eu), praseodymium (Pr), terbium (Tr), dysprosium (Dy), holmium (Ho), erbium (Er), thulium (Tm), ytterbium (Yb) and lutetium (Lu) or the manufacture of single domains with a mixture of several rare earths. The single domain described in the present embodiment is cylindrical. It is clear that the single domain can have any outer shape, the outer shape being in particular dependent on the process selected for manufacturing the single domain. Moreover, the device for applying a pressure on the YBCO single domain can be provided by any suitable pressing machine.

Having thus described at least one illustrative embodiment of the invention, various alterations, modifications and improvements will readily occur to those skilled in the art. Such alterations, modifications and improvements are intended to be within the spirit and scope of the invention. Accordingly, the foregoing description is by way of example only and is not intended to be limiting. The invention is limited only as defined in the following claims and the equivalent thereto.

## Claims

1. A manufacturing method of a single domain of a rare earth based superconducting oxide having a high critical temperature at a given oxygen rate, to be used as a superconductor having different electromagnetic properties in a privileged plane (ab) and in a privileged direction (c), comprising the following steps:
- manufacturing a single domain (20) of the rare earth based superconducting oxide at an intermediate oxygen rate lower than the given oxygen rate from grains or precursors of the rare earth based superconducting oxide; and
- oxygenating the single domain to increase the oxygen rate of the rare earth based superconducting oxide from the intermediate oxygen rate up to the given oxygen rate,
**characterized in that**, during oxygenation, a pressure is applied on the single domain along the c-axis.

2. The method of claim 1, wherein the manufacturing step of the rare earth based high critical temperature superconducting oxide at the intermediate oxygen rate includes a step of manufacturing an intermediate part (10) by sintering grains of the rare earth based superconducting oxide or grains of precursors of the rare earth based superconducting oxide.

3. The method of claim 2, wherein the manufacturing step of the rare earth based superconducting oxide at the intermediate oxygen rate includes a texturing step of the intermediate part (10) by germination from a seed (14).

4. The method of claim 1, wherein the pressure is applied uniformly on the single domain (15) of the rare earth based superconducting oxide at the intermediate oxygen rate.

5. The method of claim 1, wherein the pressure is about 5 MPa.

6. The method of claim 1, wherein the pressure is applied through a pressing machine comprising two flanges (16, 18) taking the single domain (15) of the superconducting oxide at the intermediate oxygen rate in sandwich, and means for drawing closer the two flanges.

7. The method of claim 1, wherein the rare earth based superconducting oxide is an oxide of barium, copper and the rare earth.

8. The method of claim 7, wherein the rare earth is yttrium.
